(19) Europäisches Patentamt / European Patent Office / Office européen des brevets

(11) **EP 3 678 255 B1**

(12) **FASCICULE DE BREVET EUROPEEN**

(45) Date de publication et mention de la délivrance du brevet:
**29.05.2024 Bulletin 2024/22**

(21) Numéro de dépôt: **19219728.3**

(22) Date de dépôt: **26.12.2019**

(51) Classification Internationale des Brevets (IPC):
*H01M 10/42* (2006.01)    *H01M 10/48* (2006.01)
*H02J 7/00* (2006.01)    *G01R 31/367* (2019.01)
*G01R 31/392* (2019.01)    *H01M 10/0525* (2010.01)
*G01R 31/385* (2019.01)

(52) Classification Coopérative des Brevets (CPC):
**H01M 10/425; G01R 31/367; G01R 31/392; H01M 10/48; H02J 7/0069;** G01R 31/3865; H01M 10/0525; H01M 2010/4271; H02J 7/0048; Y02E 60/10

(54) **PROCÉDÉ D'ÉTALONNAGE D'UNE FAMILLE D'ÉLÉMENTS DE BATTERIE LITHIUM-ION, MÉTHODE DE CHARGE, PRODUIT PROGRAMME D'ORDINATEUR ET DISPOSITIF DE CHARGE ASSOCIÉS**

VERFAHREN ZUR KALIBRIERUNG EINER FAMILIE VON LITHIUM-IONEN-BATTERIEELEMENTEN, ENTSPRECHENDE LADEMETHODE, ENTSPRECHENDES COMPUTERPROGRAMMPRODUKT UND ENTSPRECHENDE LADEVORRICHTUNG

METHOD FOR CALIBRATING A FAMILY OF LITHIUM-ION BATTERY ELEMENTS, CHARGING METHOD, ASSOCIATED COMPUTER PROGRAM PRODUCT AND CHARGING DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.01.2019 FR 1900018**

(43) Date de publication de la demande:
**08.07.2020 Bulletin 2020/28**

(73) Titulaire: **Commissariat à l'énergie atomique et aux énergies alternatives 75015 Paris (FR)**

(72) Inventeurs:
• **MARTINET, Sébastien**
  **38054 GRENOBLE CEDEX 09 (FR)**
• **ALIAS, Mélanie**
  **38054 GRENOBLE CEDEX 09 (FR)**
• **CHANDESRIS, Marion**
  **38054 GRENOBLE CEDEX 09 (FR)**
• **GENIES, Sylvie**
  **38054 GRENOBLE CEDEX 09 (FR)**
• **PILIPILI MATADI, Bramy**
  **38054 GRENOBLE CEDEX 09 (FR)**
• **SICSIC, David**
  **78180 Montigny-le-Bretonneux (FR)**

(74) Mandataire: **Brevalex Tour Trinity 1 B Place de la Défense 92400 Courbevoie (FR)**

(56) Documents cités:
WO-A1-2018/067565    WO-A2-2013/006415
DE-A1-102013 007 011    DE-A1-102016 007 479
US-A1- 2018 123 354

**Description**

**DOMAINE TECHNIQUE**

La présente invention concerne un procédé d'étalonnage d'une famille d'éléments de batterie Li-ion. L'invention concerne également une méthode de charge, un produit programme d'ordinateur et un dispositif de charge.

L'invention s'applique au domaine des batteries, plus particulièrement au domaine des batteries lithium-ion.

**ÉTAT DE LA TECHNIQUE ANTÉRIEURE**

Les batteries lithium-ion, encore notées Li-ion, présentent généralement une énergie massique plus élevée que les autres types de batteries. Il en résulte que les batteries Li-ion constituent une alternative avantageuse pour le stockage d'énergie électrique.

Aujourd'hui, les batteries Li-ion comprennent au moins un élément de batterie, chaque élément de batterie comportant une électrode dite « positive » (ou cathode) et une électrode dite « négative » (ou anode), séparées par un électrolyte. La cathode est généralement métallique, par exemple réalisée dans un composé de type oxyde de métaux de transition ou de type phosphate de lithium comprenant du lithium. En outre, l'anode comporte des particules de graphite.

Des éléments de batterie Li-ion qui comportent une anode de nature similaire (c'est-à-dire une anode avec notamment une même morphologie des particules de graphite, une même composition, un même liant et une même porosité), une cathode similaire (c'est-à-dire une cathode présentant notamment la même composition : un même liant, un même additif conducteur, une même porosité) et un électrolyte similaire (c'est-à-dire un électrolyte avec, notamment, une même conductivité ionique) définissent une « famille », au sens de la présente invention.

En fonctionnement, lors d'une charge d'une batterie Li-ion, des ions lithium $Li^+$ migrent à partir de la cathode de chaque élément de batterie pour s'insérer dans le graphite de l'anode correspondante. La migration inverse se produit lors d'une décharge de la batterie.

Bien que présentant une densité massique d'énergie élevée, de telles batteries voient généralement leurs performances se dégrader au cours du temps.

Une telle dégradation est due à la formation d'un dépôt de lithium métallique à la surface des particules de graphite de l'anode. Un tel phénomène se produit généralement lors de la charge de la batterie, et est couramment désigné par l'expression anglaise « *lithium plating »*.

Lorsqu'un tel dépôt entre en contact avec l'électrolyte, le lithium s'oxyde généralement pour former des composés de type carbonates de lithium ($ROCO_2Li$) ou des composés inorganiques ($Li_2CO_3$, LiF). Le lithium devient alors inactif d'un point de vue électrochimique, et n'est plus en mesure de participer aux réactions d'oxydo-réduction ayant lieu au niveau des électrodes.

En outre, un tel dépôt est également susceptible de se décrocher des particules de graphite de l'anode. Dans ce cas, le lithium sous forme métallique, bien qu'actif d'un point de vue électrochimique, n'est plus relié électroniquement à l'électrode et n'est donc plus susceptible d'être échangé entre les électrodes pour participer au transport de courant électrique dans les éléments de la batterie. Cette perte de lithium échangeable conduit à une chute progressive et irréversible de la capacité de la batterie.

Le phénomène de dépôt de lithium contribue à la perte de capacité de la batterie, réduisant ainsi sa durée de vie.

Le document US 2005/0233220 A1 décrit une batterie Li-ion fabriquée de façon à être moins sujette aux phénomènes de dépôt de lithium métallique que les batteries Li-ion usuelles.

Toutefois, une telle batterie ne donne pas entière satisfaction.

En effet, une telle batterie voit également ses performances se dégrader au cours du temps du fait de la formation de dépôts de lithium métallique à l'anode.

Il a noté que les documents DE 10 2013 007011 A1, US 2018/123354 A1 et DE 10 2016 007479 A1 fournissent également des enseignements pertinents vis-à-vis de la présente invention.

En effet, le document DE 10 2013 007011 A1 décrit en référence à sa figure 1, une méthode de charge d'une batterie comprenant au moins un élément de batterie Li-ion. Le document US 2018/123354 A1 décrit, en référence à sa figure 9, un procédé d'étalonnage d'une famille d'éléments de batterie Li-ion. En ce qui concerne le document DE 10 2016 007479 A1 décrit également un procédé d'étalonnage d'une famille d'éléments de batterie Li-ion.

Un but de l'invention est de proposer un procédé d'étalonnage qui permette de prolonger la durée de vie des batteries Li-ion.

**EXPOSÉ DE L'INVENTION**

A cet effet, l'invention a pour objet un procédé du type précité, comportant les étapes de :

- fourniture d'un élément de batterie de la famille, l'élément de batterie présentant une capacité surfacique initiale donnée correspondante ;
- au moins une évaluation d'un état de santé courant de l'élément de batterie fourni ;
- pour l'élément de batterie fourni, mise en oeuvre d'une pluralité de cycles successifs comprenant chacun une phase de charge et une phase de décharge, au moins deux phases de charge étant réalisées à des régimes de charge différents ;
- pour chaque phase de charge :

  • mesure d'un potentiel électrique d'une anode de l'élément de batterie fourni ;
  • calcul de la valeur d'une grandeur caractéristique prédéterminée de l'élément de batterie ;
  • détermination d'une valeur limite de la grandeur caractéristique prédéterminée pour laquelle le potentiel de l'anode devient inférieur ou égal à un seuil prédéterminé ;
  • enregistrement, dans une mémoire, de la valeur limite pour ladite famille ladite capacité surfacique initiale, le régime de charge de ladite phase de charge et l'état de santé évalué.

En effet, le phénomène de dépôt de lithium métallique se produit principalement lorsque le potentiel de l'anode devient négatif.

Un tel procédé permet de déterminer la valeur limite de la grandeur caractéristique prédéterminée, pour laquelle le potentiel de l'anode est encore positif ou nul. L'utilisation d'une telle valeur limite confère la possibilité, lors d'une charge de l'élément de batterie, d'interrompre la charge de l'élément de batterie lorsque la valeur courante de la grandeur caractéristique prédéterminée atteint la valeur limite, ou encore de réduire le régime de charge au profit d'un régime de charge plus faible, pour lequel la valeur limite de la grandeur caractéristique prédéterminée est plus élevée que la valeur limite associée au régime de charge courant. En outre, l'évaluation de l'état de santé de l'élément de batterie autorise de prendre en compte la dégradation des performances de l'élément de batterie au cours du temps.

Suivant d'autres aspects avantageux de l'invention, le procédé comporte une ou plusieurs des caractéristiques suivantes, prise(s) isolément ou suivant toutes les combinaisons techniquement possibles :

- chaque évaluation de l'état de santé courant de l'élément de batterie fourni est mise en oeuvre au cours d'un cycle correspondant ;
- le procédé d'étalonnage comporte le calcul, par régression, d'un modèle mathématique liant la valeur limite de la grandeur caractéristique prédéterminée au régime de charge ;
- le modèle mathématique lie la valeur limite de la grandeur caractéristique prédéterminée au régime de charge, à la capacité surfacique initiale de l'élément de batterie fourni et à l'état de santé de l'élément de batterie fourni ;
- le modèle mathématique est un modèle quadratique de la forme :

$$VAL_{lim} = a_0 + a_1 Q_0 + a_2 \log(C) + a_3 H + a_{12} Q_0 .\log(C) + a_{13} Q_0 .H + a_{23} \log(C).H + a_{11} Q_0^2 + a_{22} \log(C)^2 + a_{33} H^2$$

  où $VAL_{lim}$ est la valeur limite de la grandeur caractéristique prédéterminée ;
  $Q_0$ est la capacité surfacique initiale de l'élément de batterie ;
  $H$ est l'état de santé de l'élément de batterie ;
  $C$ est le régime de charge ;
  log est l'opérateur logarithme décimal ; et
  $a_0$, $a_1$, $a_2$, $a_3$, $a_{13}$, $a_{23}$, $a_{11}$, $a_{22}$ et $a_{33}$ des coefficients réels ;

- pour chaque cycle, l'élément de batterie est maintenu à température constante, au moins deux phases de charge étant réalisées à des températures différentes, la valeur limite enregistrée pour chaque phase de charge étant associée à la température correspondante, le modèle mathématique calculé liant la valeur limite de la grandeur caractéristique prédéterminée au régime de charge, à la capacité surfacique initiale de l'élément de batterie fourni, à l'état de santé de l'élément de batterie fourni ainsi qu'à la température de l'élément de batterie fourni ;
- le potentiel de l'anode est calculé à partir de la différence de potentiel entre l'anode et une électrode de référence ;
- l'électrode de référence est une électrode $Li^+/Li$, la valeur limite de la grandeur caractéristique prédéterminée étant atteinte lorsque la différence de potentiel entre l'anode et l'électrode de référence est nulle ;
- la grandeur caractéristique prédéterminée est un état de charge de l'élément de batterie, ou une tension entre une cathode et l'anode de l'élément de batterie.

En outre, l'invention a pour objet une méthode de charge comportant les étapes de :

- fourniture d'une batterie comprenant au moins un élément de batterie Li-ion appartenant à une famille d'éléments de batterie Li-ion et présentant une capacité surfacique initiale donnée ;
- évaluation d'un état de santé de chaque élément de batterie de la batterie ;
- alimentation de la batterie fournie en énergie électrique, à un régime de charge donné ;
- pour chaque élément de batterie, calcul d'une valeur limite d'une grandeur caractéristique prédéterminée correspondante, pour ladite famille, ladite capacité surfacique initiale, ledit état de santé et ledit régime de charge ;
- pour chaque élément de batterie, calcul de la valeur de la grandeur caractéristique prédéterminée ; et
- détection d'un état limite lorsque, pour au moins un élément de batterie, la valeur de la grandeur caractéristique prédéterminée atteint une fraction prédéterminée de la valeur limite correspondante.

La valeur limite est obtenue en appliquant le procédé d'étalonnage tel que défini ci-dessus.

Suivant un autre aspect avantageux de l'invention, la méthode de charge comporte une ou plusieurs des caractéristiques suivantes, prise(s) isolément ou suivant toutes les combinaisons techniquement possibles :

- la méthode de charge comporte, en outre, la réduction du régime de charge en cas de détection de l'état limite.

En outre, l'invention a pour objet un produit programme d'ordinateur comprenant des instructions de code de programme qui, lorsqu'elles sont exécutées par un ordinateur, mettent en oeuvre la méthode de charge telle que définie ci-dessus.

En outre, l'invention a pour objet un dispositif de charge comportant :

- un circuit d'alimentation configuré pour transmettre de l'énergie électrique à une batterie Li-ion, à un régime de charge donné, depuis une source d'énergie électrique ;
- un calculateur configuré pour :

  • évaluer un état de santé de chaque élément de batterie de la batterie ;
  • calculer la valeur d'une grandeur caractéristique prédéterminée relative à au moins un élément de batterie de la batterie au cours du temps ;
  • détecter un état limite lorsque la valeur de la grandeur caractéristique prédéterminée relative à au moins un élément de batterie atteint une fraction prédéterminée d'une valeur limite, la valeur limite étant fonction d'une famille et d'une capacité surfacique initiale de l'élément de batterie, de l'état de santé évalué et du régime de charge.

Suivant un autre aspect avantageux de l'invention, le calculateur est, en outre, configuré pour commander la réduction du régime de charge en cas de détection de l'état limite.

## BRÈVE DESCRIPTION DES DESSINS

L'invention sera mieux comprise à l'aide de la description qui va suivre, donnée uniquement à titre d'exemple non limitatif et faite en se référant aux dessins annexés sur lesquels :

- la figure 1 est une représentation schématique d'un élément de batterie lithium-ion ;
- la figure 2 est un organigramme illustrant un procédé d'étalonnage selon l'invention ;
- la figure 3 est un organigramme illustrant une étape cyclique du procédé d'étalonnage selon l'invention ;
- la figure 4 est un graphique représentant l'évolution d'un potentiel d'anode d'un élément de batterie Li-ion en fonction de l'état de charge, pour un régime de charge et une capacité surfacique initiale donnés de l'élément de batterie, et pour quatre valeurs distinctes de l'état de santé ;
- la figure 5 est une représentation schématique d'un dispositif de charge selon l'invention ; et
- la figure 6 est un organigramme illustrant le fonctionnement du dispositif de charge de la figure 5.

## EXPOSÉ DÉTAILLÉ DE MODES DE RÉALISATION PARTICULIERS

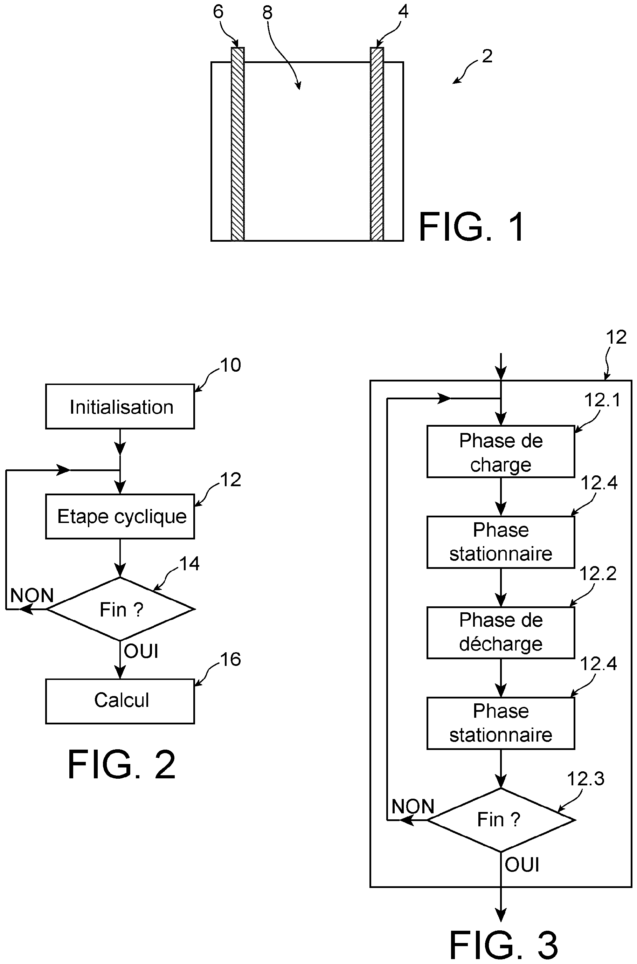

Un élément de batterie 2 est schématiquement représenté sur la figure 1. L'élément de batterie 2 est tel qu'une batterie est obtenue par le montage en série et/ou en parallèle d'une pluralité d'éléments de batterie 2. Plus précisément, l'élément de batterie 2 est un élément d'une batterie Li-ion.

De façon classique, l'élément de batterie 2 comporte une électrode dite positive, encore appelée « cathode » 4, et une électrode dite négative, encore appelée « anode » 6. La cathode 4 et l'anode 6 sont disposées à distance l'une de l'autre, l'espace entre les électrodes 4, 6 étant occupé par un électrolyte 8.

L'élément de batterie 2 présente une capacité surfacique Q, généralement exprimée en milliampère heure par centimètre carré (mAh/cm$^2$).

Par « capacité surfacique », il est entendu la capacité équivalente de la matière active par unité de surface, c'est-à-dire une capacité équivalente obtenue à partir de la capacité représentative des performances de la matière électrochimiquement active (en mAh/g) au sein des électrodes, rapportée à la surface des électrodes et multipliée par la quantité de matière active effectivement présente dans les électrodes (en grammes).

Une telle capacité surfacique varie au cours du temps et, plus spécifiquement, décroît, à partir d'une valeur maximale initiale, dite capacité surfacique initiale $Q_0$, au fur et à mesure qu'un état de santé H de l'élément de batterie 2 se dégrade.

Un tel état de santé H (en anglais, « *state of health* ») constitue un indicateur du vieillissement de l'élément de batterie 2. Un tel vieillissement provient, par exemple, d'un dépôt de lithium métallique au niveau de l'anode 6.

Des moyens d'évaluation de l'état de santé H sont, par exemple, décrits dans le document « Towards a smarter battery management system: A critical review on battery state of health monitoring methods », Rui Xiong et al., Journal of Power Sources, Volume 405, Pages 18-29 (2018). On peut citer, à titre d'exemple, la méthode de comptage coulométrique qui consiste, après une charge complète, à intégrer le courant tout au long de la décharge et obtenir ainsi la capacité de décharge au cycle n correspondant. L'indicateur d'état de santé peut alors être défini comme étant le rapport entre cette capacité de décharge au cycle n et la capacité initiale de l'accumulateur.

L'élément de batterie 2 est tel que, avant la première charge de l'élément de batterie 2, la cathode 4 comporte du lithium. Par exemple, la cathode 4 est réalisée dans un composé comprenant du lithium, tel que $LiNi_{1/3}Mn_{1/3}Co_{1/3}O_2$.

De préférence, l'anode 6 comporte des particules de graphite.

De préférence, l'électrolyte 8 est une solution d'un sel de lithium dissous dans un mélange d'alkylcarbonates. Par exemple, le sel de lithium est l'hexafluorophosphate de lithium $LiPF_6$. Par exemple, le mélange d'alkylcarbonates est un mélange de carbonate d'éthylène, de carbonate d'éthyle méthyle et de carbonate de diméthyle.

Le procédé d'étalonnage de la famille à laquelle appartient l'élément de batterie 2 est décrit en référence à la figure 2.

Une pluralité d'éléments de batterie 2 de la même famille est fournie. Au moins deux éléments de batterie 2 de la famille présentent une capacité surfacique initiale $Q_0$ différente et un état de santé H différent.

Au cours d'une étape d'initialisation 10, un élément de batterie 2 est choisi parmi la pluralité d'éléments de batterie 2. L'état de santé H de l'élément de batterie 2 choisi est évalué, c'est-à-dire calculé. En variante, l'état de santé H est évalué au cours de chaque étape cyclique 12 décrite ultérieurement.

L'élément de batterie 2 choisi est initialement déchargé.

L'élément de batterie 2 choisi est ensuite relié à un dispositif d'étalonnage (non représenté).

L'étape suivant l'étape d'initialisation 10 est une étape cyclique 12, telle que décrite ultérieurement.

Avantageusement, au cours de chaque étape cyclique 12, le dispositif d'étalonnage maintient constante la température de l'élément de batterie 2.

De préférence, le dispositif d'étalonnage est configuré pour mettre en oeuvre l'étape cyclique 12 suivant un nombre d'itérations prédéterminé. Dans ce cas, pour au moins deux mises en oeuvre distinctes de l'étape cyclique 12, les températures correspondantes sont, de préférence, différentes.

En outre, dans ce même cas où le dispositif d'étalonnage est configuré pour mettre en oeuvre l'étape cyclique 12 suivant un nombre d'itérations prédéterminé, l'étape suivant chaque étape cyclique 12 est une étape de test 14.

Durant l'étape de test 14, le dispositif d'étalonnage détermine si le nombre de fois aux cours desquelles l'étape cyclique 12 a été mise en oeuvre a atteint le nombre d'itérations prédéterminé.

Si, au cours de l'étape de test 14, le dispositif d'étalonnage détermine que l'étape cyclique 12 a été mise en oeuvre un nombre de fois strictement inférieur au nombre d'itérations prédéterminé, alors l'étape suivant l'étape de test 14 est une nouvelle étape cyclique 12. Si, au cours de l'étape de test 14, le dispositif d'étalonnage détermine que l'étape cyclique 12 a été mise en oeuvre un nombre de fois égal au nombre d'itérations prédéterminé, alors l'étape suivant l'étape de test 14 est une étape de calcul 16.

Au cours d'une étape cyclique 12 quelconque donnée, le dispositif d'étalonnage soumet l'élément de batterie 2 à un nombre prédéterminé de cycles comprenant chacun une phase de charge 12.1 et une phase de décharge 12.2 de l'élément de batterie 2, comme illustré par la figure 3.

A l'issue de chaque cycle, le dispositif d'étalonnage détermine, au cours d'une phase de contrôle 12.3, si le nombre de cycles réalisés a atteint le nombre prédéterminé de cycles. Si le nombre de cycles réalisés est strictement inférieur au nombre prédéterminé de cycles, alors un nouveau cycle comprenant une phase de charge 12.1 et une phase de décharge 12.2 est mis en oeuvre.

Si le nombre de cycles réalisés atteint le nombre prédéterminé de cycles, alors l'étape cyclique 12 est suivie de l'étape de test 14.

Durant chaque phase de charge 12.1, le dispositif d'étalonnage alimente l'élément de batterie 2 en énergie électrique à un régime de charge constant prédéterminé.

Par « régime de charge », il est entendu, au sens de la présente invention, un courant électrique calculé à partir du courant constant maximal qu'une batterie ou qu'un élément de batterie 2 est susceptible de débiter en une heure. Par exemple, pour un élément de batterie susceptible de débiter 1000 mA (milliampère) en une heure, le régime de charge 1C correspond à un courant de 1000 mA, le régime de charge C/10 correspond à un courant électrique de 100 mA, le régime de charge 3C correspond à un courant électrique de 3000 mA, etc.

De préférence, pour chaque phase de charge 12.1 d'une même étape cyclique 12, le dispositif d'étalonnage charge l'élément de batterie 2 à un régime de charge supérieur au régime de charge associé à la phase de charge 12.1 précédente. Par exemple, le régime de charge vaut successivement C/10, puis C/2, puis 0,75C, puis 1C, puis 1,25C, puis 1,5C, puis 2C, puis 3C, puis 5C.

En outre, le dispositif d'étalonnage mesure, durant chaque phase de charge 12.1 de l'étape cyclique 12, la tension aux bornes de l'élément de batterie 2.

En outre, durant chaque phase de charge 12.1, le dispositif d'étalonnage mesure le potentiel de l'anode 6 de l'élément de batterie 2. Un tel potentiel de l'anode 6 décroît généralement avec l'accroissement d'un état de charge $S$ de l'élément de batterie 2, tel que défini ultérieurement.

De préférence, le dispositif d'étalonnage calcule le potentiel de l'anode 6 à partir d'une mesure de différence de potentiel entre l'anode 6 et une électrode de référence présentant un potentiel fixe au cours du temps, par exemple une électrode au lithium $Li^+/Li$ classiquement connue.

En outre, au cours de chaque phase de charge 12.1, le dispositif d'étalonnage calcule l'état de charge $S$ de l'élément de batterie 2.

L'état de charge $S$ à un instant donné de l'étape cyclique 12 est un pourcentage défini comme le résultat de la division de la capacité de l'élément de batterie 2 à l'instant considéré, par la capacité maximale de l'élément de batterie 2 à l'issue de la phase de charge associée au régime de charge le plus faible de l'étape cyclique 12, multiplié par 100, comme cela ressort de la formule (1) :

$$S(t)=100\ \frac{q(t)}{q_{max}}\quad(1)$$

où $S(t)$ est l'état de charge à un instant $t$ donné ;

$q(t)$ est la capacité de l'élément de batterie 2 à l'instant $t$ considéré ; et

$q_{max}$ est la capacité maximale de l'élément de batterie 2 à l'issue de la phase de charge associée au régime de charge le plus faible de l'étape cyclique 12.

Par exemple, dans le cas où le régime de charge le plus faible durant l'étape cyclique 12 est C/10, $q_{max}$ est la capacité maximale de l'élément de batterie 2 à l'issue de la phase de charge associée au régime de charge C/10.

La capacité $q(t)$ de l'élément de batterie 2 à l'instant $t$ est, par exemple, prise égale à l'intégrale, entre un instant initial prédéterminé et l'instant courant $t$, de la valeur mesurée du courant circulant à travers l'élément de batterie 2. La valeur de la capacité $q(t)$ est positive. L'instant initial prédéterminé est, par exemple, l'instant auquel débute la phase de charge 12.1.

L'état de charge $S$ est croissant au cours de la phase de charge 12.1.

L'état de charge $S$ constitue une grandeur caractéristique prédéterminée de l'élément de batterie 2, dont la valeur est représentative de la valeur du potentiel électrique de l'anode 6.

Au cours de chaque phase de charge 12.1, le dispositif d'étalonnage détermine également une valeur limite $VAL_{lim}$ de l'état de charge $S$, pour laquelle la différence de potentiel entre l'anode 6 et l'électrode de référence devient inférieure ou égale à un seuil prédéterminé. Avantageusement, dans le cas où l'électrode de référence est une électrode de référence au lithium, la valeur limite $VAL_{lim}$ correspond à une différence de potentiel nulle entre l'anode 6 et l'électrode de référence.

Le dispositif d'étalonnage enregistre la valeur limite $VAL_{lim}$, la valeur limite $VAL_{lim}$ étant associée à la famille de l'élément de batterie 2 choisi, à la capacité surfacique initiale $Q_0$ de l'élément de batterie 2 choisi, à l'état de santé $H$ de l'élément de batterie 2 choisi et au régime de charge de la phase de charge 12.1 considérée. De préférence, si les étapes cycliques 12 sont mises en oeuvre à des températures respectives différentes, la valeur limite $VAL_{lim}$ enregistrée est également associée à la température respective à laquelle l'élément de batterie 2 choisi est maintenu durant chaque étape cyclique 12.

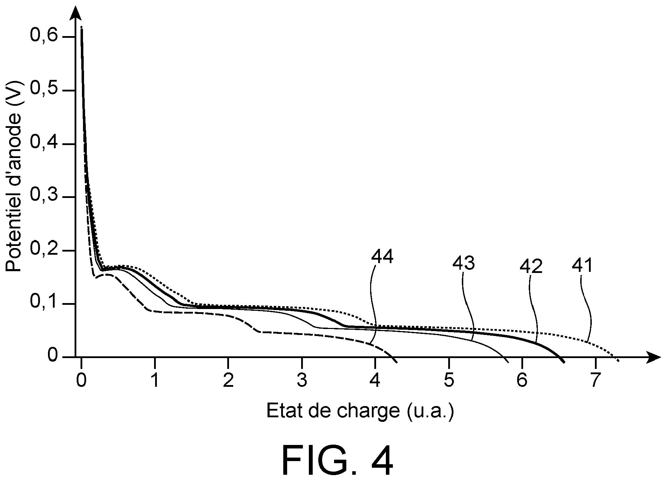

A titre d'exemple, le graphique de la figure 4 illustre l'évolution du potentiel d'anode d'un élément de batterie 2 Li-ion en fonction de son état de charge $S$, pour un même régime de charge et une même capacité surfacique initiale $Q_0$ donnés de l'élément de batterie 2, pour quatre valeurs distinctes de l'état de santé $H$, la température étant ici constante et identique pour l'ensemble des mesures.

La courbe 41 (pointillés) illustre l'évolution du potentiel d'anode en fonction de l'état de charge $S$, lorsque l'élément de batterie 2 présente un état de santé de 100%.

La courbe 42 (trait plein épais) illustre l'évolution du potentiel d'anode en fonction de l'état de charge S, lorsque l'élément de batterie 2 présente un état de santé de 90%.

La courbe 43 (trait plein fin) illustre l'évolution du potentiel d'anode en fonction de l'état de charge S, lorsque l'élément de batterie 2 présente un état de santé de 80%.

La courbe 44 (tirets) illustre l'évolution du potentiel d'anode en fonction de l'état de charge S, lorsque l'élément de batterie 2 présente un état de santé de 60%.

Il apparaît que, pour une température et une capacité surfacique initiale $Q_0$ donnés, la valeur limite $VAL_{lim}$ de l'état de charge S, c'est-à-dire la valeur de l'état de charge S pour laquelle le potentiel d'anode s'annule, est d'autant plus faible que l'état de santé H de l'élément de batterie 2 est faible.

Le dispositif d'étalonnage met fin à chaque phase de charge 12.1 lorsqu'une condition prédéterminée est remplie. Par exemple, le dispositif d'étalonnage met fin à chaque phase de charge 12.1 lorsque la tension aux bornes de l'élément de batterie 2 atteint une tension maximale prédéterminée.

Durant chaque phase de décharge 12.2, le dispositif d'étalonnage prélève de l'énergie électrique à l'élément de batterie 2, à un régime de charge prédéterminé.

Par exemple, le dispositif d'étalonnage prélève de l'énergie à l'élément de batterie 2 à un régime de charge identique pour toutes les phases de décharge 12.2 de l'étape cyclique 12, par exemple un régime de charge valant C/10.

Le dispositif d'étalonnage met fin à chaque phase de décharge 12.2 lorsqu'une condition prédéterminée est remplie. Par exemple, le dispositif d'étalonnage met fin à la phase de décharge 12.2 lorsque la tension aux bornes de l'élément de batterie 2 atteint une tension minimale prédéterminée, strictement inférieure à la tension maximale prédéterminée.

Les tensions minimale et maximale prédéterminées dépendent notamment de la nature des matériaux présents au sein de l'élément de batterie 2.

Les tensions minimale et maximale prédéterminées sont choisies de sorte à atteindre un état de lithiation limite permettant de préserver la structure d'insertion des matériaux mis en oeuvre dans l'élément de batterie 2.

En outre, l'électrolyte 8 est choisi pour être stable au moins entre la tension minimale et la tension maximale prédéterminées.

Par exemple, les tensions minimale et maximale prédéterminées pour un élément de batterie Gr/NMC (c'est-à-dire graphite/$LiNi_{1/3}Mn_{1/3}Co_{1/3}O_2$) connu valent respectivement 2,7 V et 4,2 V. Selon un autre exemple, les tensions minimale et maximale prédéterminées pour un élément de batterie Gr/LFP (c'est-à-dire graphite/$LiFePO_4$) connu valent respectivement 2,0 V et 3,6 V.

De préférence, au moins une phase de charge 12.1 ou au moins une phase de décharge 12.2 de l'étape cyclique 12 est suivie d'une phase stationnaire 12.4. Durant chaque phase stationnaire 12.4, aucun échange d'énergie électrique ne se produit entre le dispositif d'étalonnage et l'élément de batterie 2. Chaque phase stationnaire présente une durée prédéterminée, par exemple 30 minutes.

Avantageusement, une fois que l'étape d'initialisation 10 et la pluralité d'étapes cycliques 12 ont été mises en oeuvre pour l'élément de batterie 2, l'étape d'initialisation 10 et la pluralité d'étapes cycliques 12 sont mises en oeuvre pour un autre élément de batterie 2 parmi la pluralité d'éléments de batterie 2 de la même famille qui a été initialement fournie.

Dans ce cas, le dispositif d'étalonnage utilise les valeurs limites $VAL_{lim}$ obtenues pour divers régimes de charge, différentes capacités surfaciques initiales d'éléments de batterie 2 et différents états de santé pour calculer, par régression, les paramètres d'un modèle mathématique liant la valeur limite $VAL_{lim}$ au régime de charge, à la capacité surfacique initiale $Q_0$ de l'élément de batterie 2 et à l'état de santé de l'élément de batterie 2.

Par exemple, le modèle est un modèle quadratique de la forme :

$$VAL_{lim} = a_0 + a_1 Q_0 + a_2 \log(C) + a_3 H + a_{12} Q_0.\log(C) + a_{13} Q_0.H + a_{23} \log(C).H + a_{11} Q_0^2 + a_{22} \log(C)^2 + a_{33} H^2$$

où $VAL_{lim}$ est la valeur limite de l'état de charge S, exprimée en pourcent ;

$Q_0$ est la capacité surfacique initiale de l'élément de batterie 2, exprimée en milliampère heure par centimètre carré ;

H est l'état de santé de l'élément de batterie 2, exprimé en pourcent ;

C est le régime de charge ;

log est l'opérateur logarithme décimal ; et

$a_0$, $a_1$, $a_2$, $a_3$, $a_{12}$, $a_{23}$, $a_{11}$, $a_{22}$ et $a_{33}$ sont des coefficients réels obtenus par régression et dépendant de la famille de batteries étalonnée.

Par exemple, à partir des données ayant permis de construire les courbes de la figure 4 (régime de charge égal à C/10, capacité surfacique initiale valant 7,61 mAh/cm$^2$), le modèle obtenu s'écrit, pour la valeur limite de l'état de charge S :

$$VAL_{lim} = -1{,}51 - 0{,}1970.Q_0 + 21{,}2.\log(C) + 0{,}3475.H - 0{,}866.\log(C).H + 20{,}51.\log(C)^2$$

De préférence, si l'étape cyclique 12 est mise en oeuvre à différentes températures, de sorte que la valeur limite $VAL_{lim}$ prend des valeurs associées à des températures différentes, le dispositif d'étalonnage utilise les valeurs limites $VAL_{lim}$ obtenues pour diverses températures, divers régimes de charge, différentes capacités surfaciques initiales d'éléments de batterie 2 et différents états de santé pour calculer, par régression, les paramètres d'un modèle mathématique liant la valeur limite $VAL_{lim}$ au régime de charge, à la température de l'élément de batterie 2, à la capacité surfacique initiale $Q_0$ de l'élément de batterie 2 et à l'état de santé de l'élément de batterie 2.

En variante, durant la mise en oeuvre du procédé d'étalonnage, la grandeur caractéristique prédéterminée choisie est la tension U entre la cathode 4 et l'anode 6 de l'élément de batterie 2 choisi. En d'autres termes, la tension U est prise comme grandeur dont la valeur est représentative de la valeur du potentiel électrique de l'anode 6.

Dans ce cas, la mise en oeuvre du procédé d'étalonnage diffère de la mise en oeuvre précédemment décrite en ce qui suit.

Au cours de chaque phase de charge 12.1, le dispositif d'étalonnage ne calcule pas l'état de charge S de l'élément de batterie 2, mais mesure la tension U entre les électrodes 4, 6 de l'élément de batterie 2. La tension U est croissante au cours de la phase de charge 12.1.

En outre, au cours de chaque phase de charge 12.1, le dispositif d'étalonnage détermine une valeur limite $VAL_{lim}$ de la tension U pour laquelle la différence de potentiel entre l'anode 6 et l'électrode de référence devient inférieure ou égale à un seuil prédéterminé.

En outre, au cours de chaque phase de charge 12.1, le dispositif d'étalonnage enregistre la valeur limite $VAL_{lim}$ de la tension U, la valeur limite $VAL_{lim}$ étant associée à la famille de l'élément de batterie 2 choisi, à la capacité surfacique initiale de l'élément de batterie 2 choisi, à l'état de santé de l'élément de batterie choisi et au régime de charge de la phase de charge 12.1 considérée.

En outre, le dispositif d'étalonnage utilise les limite $VAL_{lim}$ de la tension U obtenues pour divers régimes de charge et différentes capacités surfaciques initiales et différents états de santé d'éléments de batterie pour calculer, par régression, les paramètres d'un modèle mathématique liant la valeur limite $VAL_{lim}$ de la tension U au régime de charge et à la capacité surfacique initiale $Q_0$ et à l'état de santé H de l'élément de batterie 2.

Par exemple, le modèle est un modèle quadratique de la forme :

$$VAL_{lim} = b_0 + b_1 Q_0 + b_2 \log(C) + b_3 H + b_{12} Q_0.\log(C) + b_{13} Q_0.H + b_{23} \log(C).H + b_{11} Q_0^2 + b_{22} \log(C)^2 + b_{33} H^2$$

où $VAL_{lim}$ est la valeur limite de la tension, exprimée en volt ;
$Q_0$ est la capacité surfacique initiale de l'élément de batterie 2, exprimée en milliampère heure par centimètre carré ;
C est le régime de charge ;
H est l'état de santé de l'élément de batterie 2, exprimé en pourcent ;
log est l'opérateur logarithme décimal ; et
$b_0$, $b_1$, $b_2$, $b_3$, $b_{13}$, $b_{23}$, $b_{11,}$ $b_{22}$ et $b_{33}$ sont des coefficients réels obtenus par régression et dépendant de la famille de batteries étalonnée.

De préférence, si l'étape cyclique 12 est mise en oeuvre à différentes températures, de sorte que la valeur limite $VAL_{lim}$ de la tension U prend des valeurs associées à des températures différentes, le dispositif d'étalonnage utilise les valeurs limites $VAL_{lim}$ obtenues pour diverses températures, divers régimes de charge, différentes capacités surfaciques initiales d'éléments de batterie 2 et différents états de santé pour calculer, par régression, les paramètres d'un modèle mathématique liant la valeur limite $VAL_{lim}$ de la tension au régime de charge, à la température de l'élément de batterie 2, à la capacité surfacique initiale $Q_0$ de l'élément de batterie 2 et à l'état de santé H de l'élément de batterie 2.

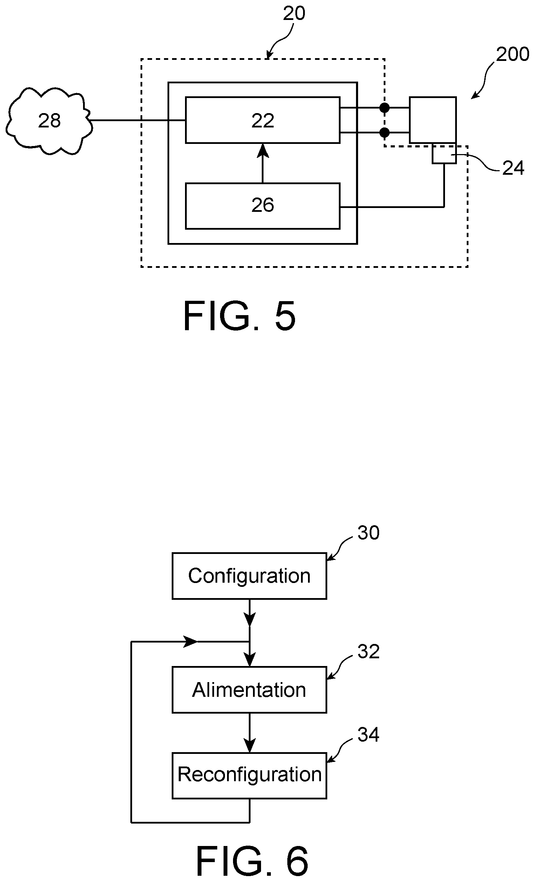

Un dispositif de charge 20 selon l'invention, relié à une batterie 200 à charger, est représenté sur la figure 5.

La batterie 200 est obtenue par mise en série et/ou en parallèle d'éléments de batterie 2 identiques.

Le dispositif de charge 20 comporte un circuit d'alimentation 22 et un calculateur 26.

De préférence, le dispositif de charge 20 comporte également au moins un capteur de température 24, chaque capteur de température 24 étant configuré pour mesurer la température de la batterie 200.

Le circuit d'alimentation 22 est configuré pour transmettre de l'énergie électrique à la batterie 200, depuis une source d'énergie électrique 28. Plus précisément, le circuit d'alimentation 22 est configuré pour transmettre de l'énergie électrique à la batterie 200 à un régime de charge prédéterminé.

Le calculateur 26 est configuré pour calculer la valeur de la grandeur caractéristique prédéterminée relative à chaque élément de batterie 2 de la batterie 200 au cours du temps. Par exemple, le calculateur 26 est configuré pour calculer l'état de charge de chaque élément de batterie 2 de la batterie 200 au cours du temps. En variante, le calculateur 26 est configuré pour calculer la tension entre les électrodes 4, 6 de chaque élément de batterie 2 de la batterie 200 au cours du temps.

Le calculateur 26 est également configuré pour stocker, pour au moins une famille d'éléments de batterie 2, le modèle de la valeur limite $VAL_{lim}$, pour la grandeur caractéristique prédéterminée, qui a été obtenu selon le procédé d'étalonnage tel que décrit précédemment.

Le calculateur 26 est également configuré pour évaluer l'état de santé H de chaque élément de batterie 2 de la batterie 200.

En outre, le calculateur 26 est configuré pour calculer la valeur limite $VAL_{lim}$ de la grandeur caractéristique prédéterminée choisie pour chaque élément de batterie 2 de la batterie 200 à charger, en fonction de la famille des éléments de batterie 2, de la capacité surfacique initiale des éléments de batterie 2, de l'état de santé H évalué pour chaque élément de batterie 2 et du régime de charge suivant lequel le circuit d'alimentation 22 fournit de l'énergie électrique à la batterie 200.

En outre, le calculateur 26 est configuré pour détecter une situation, dite « état limite », dans laquelle la valeur de la grandeur caractéristique prédéterminée relative à au moins un élément de batterie 2 atteint une fraction prédéterminée de la valeur limite $VAL_{lim}$ correspondante.

Le calculateur 26 est également configuré pour commander le régime de charge suivant lequel le circuit d'alimentation 22 fournit de l'énergie électrique à la batterie 200.

En particulier, le calculateur 26 est configuré pour commander, en cas de détection de l'état limite, la réduction du régime de charge suivant lequel le circuit d'alimentation 22 fournit de l'énergie électrique à la batterie 200.

La charge de la batterie 200 au moyen du dispositif de charge 20 est décrite en référence à la figure 6.

Au cours d'une étape de configuration 30, une batterie 200 comprenant des éléments de batterie 2 identiques d'une famille de batteries Li-ion donnée, et présentant une capacité surfacique initiale $Q_0$ et un état de santé H donnés, est fournie.

Un opérateur renseigne l'architecture de la batterie 200 dans le dispositif de charge 20. En particulier, l'opérateur renseigne la façon dont les éléments de batterie 2 de la batterie 200 sont connectés entre eux.

L'opérateur renseigne également, dans le dispositif de charge 20, la famille et la capacité surfacique initiale des éléments de batterie 2 de la batterie 200.

Puis, le dispositif de charge 20 évalue l'état de santé de chaque élément de batterie 2 de la batterie 200.

Puis, le dispositif de charge 20 charge le modèle mathématique de la charge limite $VAL_{lim}$ pour la famille correspondant aux éléments de batterie 2 de la batterie 200.

En variante, le dispositif de charge 20 est destiné à charger des batteries 200 prédéterminées, comportant des éléments de batterie 2 identiques. Dans ce cas, l'intervention de l'opérateur durant l'étape de configuration 30 n'est pas requise, les informations relatives à la famille et la capacité surfacique initiale des éléments de batterie 2 de la batterie 200, ainsi qu'à l'architecture de la batterie 200, étant préenregistrée dans le dispositif de charge 20.

Selon une autre variante, le dispositif de charge 20 comporte un détecteur (non représenté) configuré pour identifier la batterie 200, c'est-à-dire pour déterminer l'architecture des éléments de batterie 2, ainsi que la famille et la capacité surfacique initiale des éléments de batterie 2 de la batterie 200. Dans ce cas, l'intervention de l'opérateur durant l'étape de configuration 30 n'est pas requise, les informations relatives à la famille et la capacité surfacique initiale des éléments de batterie 2 de la batterie 200, ainsi qu'à l'architecture de la batterie 200, étant préenregistrée dans le dispositif de charge 20.

Puis, au cours d'une étape d'alimentation 32, le circuit d'alimentation 22 fournit de l'énergie électrique à la batterie 200, à un régime de charge donné.

En outre, au cours de l'étape d'alimentation 32, chaque capteur de température 24 mesure, de préférence, la température de la batterie 200.

Durant l'étape d'alimentation 32, le calculateur 26 calcule l'état de charge limite $VAL_{lim}$ pour la famille et la capacité surfacique initiale des éléments de batterie 2, de l'état de santé de chaque élément de batterie 2 et du régime de charge suivant lequel le circuit d'alimentation 22 fournit de l'énergie électrique à la batterie 200. Avantageusement, le calculateur 26 prend également en compte la température mesurée par chaque capteur de température 24, s'il est présent, pour le calcul de l'état de charge limite $VAL_{lim}$.

En outre, au cours de l'étape d'alimentation 32, le calculateur 26 calcule l'état de charge de chaque élément de batterie 2.

Si l'état de charge d'un élément de batterie 2 de la batterie 200 atteint la fraction prédéterminée de la valeur limite $VAL_{lim}$ pour l'état de charge S, alors le calculateur 26 détecte un état limite.

En variante, le calculateur 26 calcule la tension entre les électrodes 4, 6 de chaque élément de batterie 2. Dans ce cas, si la tension entre les électrodes d'un élément de batterie 2 de la batterie 200 atteint la fraction prédéterminée de la valeur limite $VAL_{lim}$ pour la tension U, alors le calculateur 26 détecte un état limite.

En variante, le calculateur 26 évalue l'état de santé de chaque élément de batterie 2 tout au long de l'étape d'alimentation 32, la valeur de l'état de charge limite (ou la tension limite) étant mise à jour, au cours du temps, avec l'évolution de l'état de santé.

De préférence, en cas de détection d'un état limite, au cours d'une étape de reconfiguration 34 successive à l'étape d'alimentation, le calculateur 26 commande au circuit d'alimentation 22 de sélectionner un nouveau régime de charge distinct du régime de charge de l'étape d'alimentation 32 précédente, de préférence strictement inférieur au régime de charge de l'étape d'alimentation 32 précédente.

Par exemple, dans le cas où la grandeur caractéristique prédéterminée est l'état de charge S, au cours de l'étape de reconfiguration 34, le calculateur 26 commande au circuit d'alimentation 22 de sélectionner un nouveau régime de charge strictement inférieur au régime de charge de l'étape d'alimentation 32 précédente.

L'étape successive à l'étape de reconfiguration 34 est l'étape d'alimentation 32, le circuit d'alimentation 22 fournissant de l'énergie électrique à la batterie 200 suivant le nouveau régime de charge.

## Revendications

**1.** Procédé d'étalonnage d'une famille d'éléments (2) de batterie Li-ion, **caractérisé en ce qu'**il comporte les étapes de :

- fourniture d'un élément de batterie (2) de la famille, l'élément de batterie (2) présentant une capacité surfacique initiale donnée correspondante ;
- au moins une évaluation d'un état de santé courant de l'élément de batterie (2) fourni ;
- pour l'élément de batterie (2) fourni, mise en oeuvre d'une pluralité de cycles successifs comprenant chacun une phase de charge (12.1) et une phase de décharge (12.2), au moins deux phases de charge (12.1) étant réalisées à des régimes de charge différents ;
- pour chaque phase de charge :

  • mesure d'un potentiel électrique d'une anode (6) de l'élément de batterie (2) fourni ;
  • calcul de la valeur d'une grandeur caractéristique prédéterminée de l'élément de batterie (2) ;
  • détermination d'une valeur limite de la grandeur caractéristique prédéterminée pour laquelle le potentiel de l'anode (6) devient inférieur ou égal à un seuil prédéterminé ;
  • enregistrement, dans une mémoire, de la valeur limite pour ladite famille ladite capacité surfacique initiale, le régime de charge de ladite phase de charge (12.1) et l'état de santé évalué.

**2.** Procédé d'étalonnage selon la revendication 1, dans lequel chaque évaluation de l'état de santé courant de l'élément de batterie (2) fourni est mise en oeuvre au cours d'un cycle correspondant.

**3.** Procédé d'étalonnage selon la revendication 1 ou 2, comportant le calcul, par régression, d'un modèle mathématique liant la valeur limite de la grandeur caractéristique prédéterminée au régime de charge.

**4.** Procédé d'étalonnage selon la revendication 3, dans lequel le modèle mathématique lie la valeur limite de la grandeur caractéristique prédéterminée au régime de charge, à la capacité surfacique initiale de l'élément de batterie (2) fourni et à l'état de santé de l'élément de batterie (2) fourni.

**5.** Procédé d'étalonnage selon la revendication 4, dans lequel le modèle mathématique est un modèle quadratique de la forme :

$$VAL_{lim} = a_0 + a_1 Q_0 + a_2 \log(C) + a_3 H + a_{12} Q_0 . \log(C) + a_{13} Q_0 . H + a_{23} \log(C) . H + a_{11} Q_0^2 + a_{22} \log(C)^2 + a_{33} H^2$$

où $VAL_{lim}$ est la valeur limite de la grandeur caractéristique prédéterminée ;
$Q_0$ est la capacité surfacique initiale de l'élément de batterie (2) ;
$H$ est l'état de santé de l'élément de batterie (2) ;
$C$ est le régime de charge ;
log est l'opérateur logarithme décimal ; et
$a_0$, $a_1$, $a_2$, $a_3$, $a_{13}$, $a_{23}$, $a_{11}$, $a_{22}$ et $a_{33}$ des coefficients réels.

**6.** Procédé d'étalonnage selon la revendication 4, dans lequel, pour chaque cycle, l'élément de batterie (2) est maintenu à température constante, au moins deux phases de charge (12.1) étant réalisées à des températures différentes,

la valeur limite enregistrée pour chaque phase de charge étant associée à la température correspondante, le modèle mathématique calculé liant la valeur limite de la grandeur caractéristique prédéterminée au régime de charge, à la capacité surfacique initiale de l'élément de batterie (2) fourni, à l'état de santé de l'élément de batterie (2) fourni ainsi qu'à la température de l'élément de batterie (2) fourni.

7.  Procédé d'étalonnage selon l'une quelconque des revendications 1 à 6, dans lequel le potentiel de l'anode (6) est calculé à partir de la différence de potentiel entre l'anode (6) et une électrode de référence.

8.  Procédé d'étalonnage selon la revendication 7, dans lequel l'électrode de référence est une électrode Li$^+$/Li, la valeur limite de la grandeur caractéristique prédéterminée étant atteinte lorsque la différence de potentiel entre l'anode (6) et l'électrode de référence est nulle.

9.  Procédé d'étalonnage selon l'une quelconque des revendications 1 à 8, dans lequel la grandeur caractéristique prédéterminée est un état de charge de l'élément de batterie (2), ou une tension entre une cathode (4) et l'anode (6) de l'élément de batterie (2).

10. Méthode de charge comportant les étapes de :

    - fourniture d'une batterie (200) comprenant au moins un élément de batterie (2) Li-ion appartenant à une famille d'éléments de batterie Li-ion et présentant une capacité surfacique initiale donnée ;
    - évaluation d'un état de santé de chaque élément de batterie (2) de la batterie (200) ;
    - alimentation de la batterie (200) fournie en énergie électrique, à un régime de charge donné ;
    - pour chaque élément de batterie (2), calcul d'une valeur limite d'une grandeur caractéristique prédéterminée correspondante, pour ladite famille, ladite capacité surfacique initiale, ledit état de santé et ledit régime de charge ;
    - pour chaque élément de batterie (2), calcul de la valeur de la grandeur caractéristique prédéterminée ; et
    - détection d'un état limite lorsque, pour au moins un élément de batterie (2), la valeur de la grandeur caractéristique prédéterminée atteint une fraction prédéterminée de la valeur limite correspondante,

    dans laquelle la valeur limite est obtenue en appliquant le procédé d'étalonnage selon l'une quelconque des revendications 1 à 9.

11. Méthode selon la revendication 10, comportant, en outre, la réduction du régime de charge en cas de détection de l'état limite.

12. Produit programme d'ordinateur comprenant des instructions de code de programme qui, lorsqu'elles sont exécutées par un ordinateur, mettent en oeuvre les étapes d'évaluation, de calcul de la valeur limite, de calcul de la valeur de la grandeur caractéristique prédéterminée et de détection de la méthode selon la revendication 10.

13. Dispositif de charge comportant :

    - un circuit d'alimentation configuré pour transmettre de l'énergie électrique à une batterie (200) Li-ion, à un régime de charge donné, depuis une source (28) d'énergie électrique ;
    - un calculateur (26) configuré pour :

      • évaluer un état de santé de chaque élément de batterie (2) de la batterie (200) ;
      • calculer la valeur d'une grandeur caractéristique prédéterminée relative à au moins un élément de batterie (2) de la batterie (200) au cours du temps ;
      • détecter un état limite lorsque la valeur de la grandeur caractéristique prédéterminée relative à au moins un élément de batterie (2) atteint une fraction prédéterminée d'une valeur limite, la valeur limite étant fonction d'une famille et d'une capacité surfacique initiale de l'élément de batterie (2), de l'état de santé évalué et du régime de charge.

14. Dispositif selon la revendication 13, dans lequel le calculateur (26) est, en outre, configuré pour commander la réduction du régime de charge en cas de détection de l'état limite.

**Patentansprüche**

1. Verfahren zum Kalibrieren einer Familie von Elementen (2) einer Li-Ion Batterie, **dadurch gekennzeichnet, dass** es die Schritte beinhaltet, zur:

   - Bereitstellung eines Batterieelements (2) der Familie, wobei das Batterieelement (2) eine entsprechende gegebene anfängliche Flächenkapazität aufweist;
   - mindestens einen Bewertung eines laufenden Gesundheitszustands des bereitgestellten Batterieelements (2);
   - Umsetzung, für das bereitgestellte Batterieelement (2), einer Vielzahl von aufeinanderfolgenden Zyklen, die jeweils eine Ladephase (12.1) und eine Entladephase (12.2) umfassen, wobei mindestens zwei Ladephasen (12.1) mit unterschiedlichen Laderegelungen durchgeführt werden;
   - für jede Ladephase:

     · Messen eines elektrischen Potenzials einer Anode (6) des bereitgestellten Batterieelements (2);
     · Berechnen des Wertes einer zuvor bestimmten charakteristischen Größe des Batterieelements (2);
     · Bestimmen eines Grenzwertes der zuvor bestimmten charakteristischen Größe, bei dem das Potenzial der Anode (6) kleiner oder gleich einer zuvor bestimmten Schwelle wird;
     · Speichern in einem Speicher des Grenzwerts für die Familie, der anfänglichen Flächenkapazität, der Laderegelung der Ladephase (12.1) und des bewerteten Gesundheitszustandes.

2. Verfahren zum Kalibrieren nach Anspruch 1, wobei jede Bewertung des laufenden Gesundheitszustandes des bereitgestellten Batterieelements (2) im Laufe eines entsprechenden Zyklus umgesetzt wird.

3. Verfahren zum Kalibrieren nach Anspruch 1 oder 2, welches die Regressionsberechnung eines mathematischen Modells beinhaltet, die den Grenzwert der zuvor bestimmten charakteristischen Größe mit der Laderegelung verknüpft.

4. Verfahren zum Kalibrieren nach Anspruch 3, wobei das mathematische Modell den Grenzwert der zuvor bestimmten charakteristischen Größe mit der Laderegelung, der anfänglichen Flächenkapazität des bereitgestellten Batterieelements (2) und dem Gesundheitszustand des bereitgestellten Batterieelements (2) verknüpft.

5. Verfahren zum Kalibrieren nach Anspruch 4, wobei das mathematische Modell ein quadratisches Modell der folgenden Form ist:

$$VAL_{lim} = a_0 + a_1 Q_0 + a_2 \log(C) + a_3 H + a_{12} Q_0.\log(C) + a_{13} Q_0.H + a_{23}\log(C).H + a_{11} Q_0^2$$
$$+ a_{22}\log(C)^2 + a_{33} H^2$$

   wobei $VAL_{lim}$ der Grenzwert der zuvor bestimmten charakteristischen Größe ist;
   $Q_0$ die anfängliche Flächenkapazität des Batterieelements (2) ist;
   H der Gesundheitszustand des Batterieelements (2) ist;
   C die Laderegelung ist;
   log der Zehnerlogarithmus-Operator ist;
   $a_0$, $a_1$, $a_2$, $a_3$, $a_{13}$, $a_{23}$, $a_{11}$, $a_{22}$ und $a_{33}$ reelle Koeffizienten sind.

6. Verfahren zum Kalibrieren nach Anspruch 4, wobei das Batterieelement (2) für jeden Zyklus auf einer konstanten Temperatur gehalten wird, wobei mindestens zwei Ladephasen (12.1) bei unterschiedlichen Temperaturen durchgeführt werden,

   wobei der für jede Ladephase gespeicherte Grenzwert der entsprechenden Temperatur zugeordnet wird,
   wobei das berechnete mathematische Modell den Grenzwert der zuvor bestimmten charakteristischen Größe mit der Laderegelung, der anfänglichen Flächenkapazität des bereitgestellten Batterieelements (2), dem Gesundheitszustand des bereitgestellten Batterieelements (2), sowie der Temperatur des bereitgestellten Batterieelements (2) verknüpft.

7. Verfahren zum Kalibrieren nach einem der Ansprüche 1 bis 6, wobei das Potenzial der Anode (6) aus der Potenzialdifferenz zwischen der Anode (6) und einer Bezugselektrode berechnet wird.

**8.** Verfahren zum Kalibrieren nach Anspruch 7, wobei die Bezugselektrode eine Li$^+$/Li Elektrode ist, wobei der Grenzwert der zuvor bestimmten charakteristischen Größe erreicht ist, wenn die Potenzialdifferenz zwischen der Anode (6) und einer Bezugselektrode null ist.

**9.** Verfahren zum Kalibrieren nach einem der Ansprüche 1 bis 8, wobei die zuvor bestimmte charakteristische Größe ein Ladezustand des Batterieelements (2), oder eine Spannung zwischen einer Kathode (4) und der Anode (6) des Batterieelements (2) ist.

**10.** Methode zum Laden, welche die Schritte umfasst, zur:

- Bereitstellung einer Batterie (200), die mindestens ein Li-Ion-Batterieelement (2) umfasst, das einer Familie an Li-Ion-Batterieelementen angehört, und eine gegebene anfängliche Flächenkapazität aufweist;
- Bewertung eines laufenden Gesundheitszustands eines jeden Batterieelements (2) der Batterie (200);
- Versorgung der bereitgestellten Batterie (200) mit elektrischer Energie, bei einer gegebenen Laderegelung;
- Berechnung für jedes Batterieelement (2) eines Grenzwertes einer entsprechenden zuvor bestimmten charakteristischen Größe für die Familie, die anfängliche Flächenkapazität, den Gesundheitszustand und die Laderegelung;
- Berechnung für jedes Batterieelement (2) des Wertes der zuvor bestimmten charakteristischen Größe; und
- Erkennung eines Grenzzustandes, wenn der Wert der zuvor bestimmten charakteristischen Größe für mindestens ein Batterieelement (2) eine zuvor bestimmte Fraktion des entsprechenden Grenzwertes erreicht,

wobei der Grenzwert durch Anwenden des Verfahrens zum Kalibrieren nach einem der Ansprüche 1 bis 9 erhalten wird.

**11.** Methode nach Anspruch 10, welche weiter die Reduzierung der Laderegelung im Fall des Erkennens des Grenzzustandes beinhaltet.

**12.** Computerprogrammprodukt, welches Programmcodeanweisungen umfasst, die wenn sie von einem Computer ausgeführt werden, die Schritte der Bewertung, der Berechnung des Grenzwertes, der Berechnung der zuvor bestimmten charakteristischen Größe und der Erkennung der Methode nach Anspruch 10 umsetzen.

**13.** Vorrichtung zum Laden, welche beinhaltet:

- eine Versorgungsschaltung, die konfiguriert ist, um elektrische Energie in eine Li-Ion Batterie (200) mit einer gegebenen Laderegelung aus einer elektrischen Energiequelle (28) zu übertragen;
- einen Rechner (26), der konfiguriert ist, um:

· einen Gesundheitszustand eines jeden Batterieelements (2) der Batterie (200) zu bewerten;
· den Wert einer zuvor bestimmten charakteristischen Größe in Bezug auf mindestens ein Batterieelement (2) der Batterie (200) im Laufe der Zeit zu berechnen;
· einen Grenzzustand zu erkennen, wenn der Wert der zuvor bestimmten charakteristischen Größe in Bezug auf mindestens ein Batterieelement (2) eine zuvor bestimmte Fraktion eines Grenzwertes erreicht, wobei der Grenzwert von einer Familie und von einer anfänglichen Flächenkapazität des Batterieelements (2), dem bewerteten Gesundheitszustand und der Laderegelung abhängig ist.

**14.** Vorrichtung nach Anspruch 13, wobei der Rechner (26) weiter konfiguriert ist, um die Reduzierung der Laderegelung im Falle eines Erkennens des Grenzzustandes anzusteuern.

**Claims**

**1.** Method for calibrating a family of Li-ion battery elements (2), **characterised in that** it includes the steps of:

- providing a battery element (2) of the family, the battery element (2) having a corresponding given initial surface area capacity;
- at least one evaluation of a current state of health of the battery element (2) supplied;
- for the battery element (2) supplied, implementing a plurality of successive cycles, each comprising a charging phase (12.1) and a discharging phase (12.2), at least two charging phases (12.1) being carried out at different charging rates;
- for each charging phase:

- measuring an electrical potential of an anode (6) of the battery element (2) supplied;
- calculating the value of a predetermined characteristic variable of the battery element (2);
- determining a limit value of the predetermined characteristic variable for which the potential of the anode (6) becomes less than or equal to a predetermined threshold;
- recording, in a memory, the limit value for said family the said initial surface area capacity, the charging rate of said charging phase (12.1) and the evaluated state of health.

2. Calibration method according to claim 1, wherein each evaluation of the current state of health of the battery element (2) supplied is carried out during a corresponding cycle.

3. Calibration method according to claim 1 or 2, including calculating, by regression, a mathematical model relating the limit value of the predetermined characteristic variable to the charging rate.

4. Calibration method according to claim 3, wherein the mathematical model relates the limit value of the predetermined characteristic variable to the charging rate, to the initial surface area capacity of the battery element (2) supplied and to the state of health of the battery element (2) supplied.

5. Calibration method according to claim 4, wherein the mathematical model is a quadratic model of the form:

$$VAL_{lim} = a_0 + a_1 Q_0 + a_2 \log(C) + a_3 H + a_{12} Q_0.\log(C) + a_{13} Q_0.H + a_{23}\log(C).H + a_{11} Q_0^2 + a_{22}\log(C)^2 + a_{33} H^2$$

where $VAL_{lim}$ is the limit value of the predetermined characteristic variable;
$Q_0$ is the initial surface area capacity of the battery element (2);
$H$ is the state of health of the battery element (2);
$C$ is the charging rate;
log is the decimal logarithm operator; and
$a_0$, $a_1$, $a_2$, $a_3$, $a_{13}$, $a_{23}$, $a_{11}$, $a_{22}$ and $a_{33}$ are real coefficients.

6. Calibration method according to claim 4, wherein, for each cycle, the battery element (2) is kept at a constant temperature, at least two charging phases (12.1) being carried out at different temperatures,

the limit value recorded for each charging phase being associated with the corresponding temperature,
the calculated mathematical model relating the limit value of the predetermined characteristic variable to the charging rate, to the initial surface area capacity of the battery element (2) supplied, to the state of health of the battery element (2) supplied as well as to the temperature of the battery element (2) supplied.

7. Calibration method according to any one of claims 1 to 6, wherein the potential of the anode (6) is calculated from the potential difference between the anode (6) and a reference electrode.

8. Calibration method according to claim 7, wherein the reference electrode is an Li + /Li electrode, the limit value of the predetermined characteristic variable being reached when the potential difference between the anode (6) and the reference electrode is zero.

9. Calibration method according to any one of claims 1 to 8, wherein the predetermined characteristic variable is a state of charge of the battery element (2), or a voltage between a cathode (4) and the anode (6) of the battery element (2).

10. Charging method including the steps of:

- providing a battery (200) comprising at least one Li-ion battery element (2) belonging to a family of Li-ion battery cells and having a given initial surface area capacity;
- evaluating a state of health of each battery element (2) of the battery (200);
- supplying the battery (200) supplied with electrical energy at a given charging rate;

- for each battery element (2), calculating a limit value of a corresponding predetermined characteristic variable, for said family, said initial surface area capacity, said state of health and said charging rate;
- for each battery element (2), calculating the value of the predetermined characteristic variable; and
- detecting a limit state when, for at least one battery element (2), the value of the predetermined characteristic variable reaches a predetermined fraction of the corresponding limit value,

wherein the limit value is obtained by applying the calibration method according to any one of claims 1 to 9.

**11.** Method according to claim 10, further including reducing the charging rate on detection of the limit state.

**12.** Computer program product comprising program code instructions which, when executed on a computer, implement the steps of evaluating, calculating the limit value, calculating the value of the predetermined characteristic variable and detecting the method according to claim 10.

**13.** Charging device including:

- a supply circuit configured to transmit electrical energy to an Li-ion battery (200), at a given charging rate, from a source (28) of electrical energy;
- a computer (26) configured to:

  • evaluate a state of health of each battery element (2) of the battery (200);
  • calculate the value of a predetermined characteristic variable relating to at least one battery element (2) of the battery (200) over time;
  • detect a limit state when the value of the predetermined characteristic variable relating to at least one battery element (2) reaches a predetermined fraction of a limit value, the limit value being a function of a family and an initial surface area capacity of the battery element (2), the evaluated state of health and the charging rate.

**14.** Device according to claim 13, wherein the computer (26) is further configured to control the reduction of the charging rate in the event of detection of the limit state.

FIG. 1

FIG. 2

FIG. 3

FIG. 4

20

200

28

22

26

24

# FIG. 5

30

Configuration

32

Alimentation

34

Reconfiguration

# FIG. 6

## RÉFÉRENCES CITÉES DANS LA DESCRIPTION

**Documents brevets cités dans la description**

- US 20050233220 A1
- DE 102013007011 A1
- US 2018123354 A1
- DE 102016007479 A1

**Littérature non-brevet citée dans la description**

- **RUI XIONG et al.** Towards a smarter battery management system: A critical review on battery state of health monitoring methods. *Journal of Power Sources,* 2018, vol. 405, 18-29